# EUROPEAN PATENT APPLICATION

(11) **EP 4 456 398 A1**
(43) Date of publication of application: **30.10.2024**
(21) Application number: 23169612.1
(22) Date of filing: 24.04.2023
(51) Int. Cl.: H02M 1/14, H02M 1/32, H02M 1/08, H01L 23/495, H01L 25/16, H01L 25/065

(54) **A GALVANICALLY ISOLATED CONTROLLER**

(71) Applicant: NXP USA, Inc., Austin TX 78735 (US)
(72) Inventor: Rudiak, Jerry, Austin 78735 (US); Brauchler, Fred T, Austin 78735 (US); Carpenter, Burton Jesse, Austin 78735 (US)
(74) Representative: Schmütz, Christian Klaus Johannes

(57) **Abstract**

A gate driver comprising a first die including a first circuitry configured to operate in a first voltage domain and a second die comprising second circuity, stacked with the first die. The first dies galvanically isolated from the second die by a galvanic isolation layer. The first circuitry of the first die and the second circuitry of the second die are configured to provide an communication channel through the galvanic isolation layer. The gate driver comprising monitoring circuitry configured to receive signalling from the communication channel and determine deterioration of the galvanic isolation layer based on one or more of an amplitude, a power, a received signal strength indicator value, a phase shift and a frequency of the received signalling relative to a respective threshold.

## Description

### Field

The present disclosure relates to a gate driver. It also relates to a system comprising a first and second gate driver. The present disclosure also discloses an electric vehicle comprising the system.

### Background

Control of high voltage traction inverters such as for operating a traction motor or other electrical devices is difficult due to the need to operate in a high voltage domain. Control is usually accomplished by relaying signals into a low voltage domain and then communicating using pulsed width modulation (PWM) to a microcontroller (MCU) in the low voltage domain. Galvanically isolated controllers make use of a galvanic isolation layer to isolate components that operate in different voltage domains such as a low voltage domain (LV) from a high voltage domain (HV). Over time this galvanic isolation layer ages and its isolation properties may degrade.

### Summary

According to a first aspect of the present disclosure there is provided a gate driver comprising:
a first die including a first circuitry configured to operate in a first voltage domain;
a second die stacked with the first die and galvanically isolated therefrom by a galvanic isolation layer therebetween, the second die comprising second circuity;
wherein the first circuitry of the first die and the second circuitry of the second die are configured to provide one of an inductive and capacitive communication channel through the galvanic isolation layer between the first circuitry and the second circuitry; and
monitoring circuitry configured to receive signalling from the communication channel, the monitoring circuitry configured to determine deterioration of the galvanic isolation layer based on one or more of an amplitude, a power, a received signal strength indicator value, a phase shift and a frequency of the received signalling relative to a respective threshold.

In one or more examples, the first circuitry of the first die includes a first coil and the second circuitry of the second die includes a second coil, wherein the first and second coils are configured to provide an inductive communication channel through the galvanic isolation layer between the first circuitry and the second circuitry.

In one or more embodiments the respective threshold is a predetermined absolute threshold.

In one or more embodiments the respective threshold is a value determined from one or more of an average amplitude, an average power, an average received signal strength indicator value, an average phase shift and an average frequency signal obtained over a calibration time period.

In one or more embodiments the respective threshold is based on one or more of a corresponding amplitude, a corresponding power, a corresponding transmitted signal strength indicator value, a corresponding phase and a corresponding frequency of signalling that is transmitted via the communication channel.

In one or more embodiments the information indicative of said one or more of the corresponding amplitude, power, transmitted signal strength indicator value, phase and frequency of signalling that is transmitted via the communication channel is communicated via the communication channel for determination of the respective threshold.

In one or more embodiments the monitoring circuitry is configured to determine deterioration of the galvanic isolation layer based on the frequency of the received signalling relative to the respective threshold, wherein the monitoring circuitry is configured to determine changes in the period of the received signalling and the respective threshold is indicative of a threshold level of changes in the period.

In one or more embodiments the monitoring circuitry is part of the second circuitry.

In one or more embodiments the monitoring circuitry is part of the first circuitry.

In one or more embodiments the galvanic isolation layer comprises one of Silicon Oxide and die attach film.

In one or more embodiments, based on determination of the deterioration of the galvanic isolation layer, the monitoring circuitry is configured to output a warning signal.

In one or more embodiments the monitoring circuitry is configured to periodically awake from a low power state, make said determination of the deterioration of the galvanic isolation layer and return to the low power state.

In one or more embodiments the wherein the first circuitry is configured to operate in a low voltage domain and be coupled to a microcontroller and the second circuitry is configured to operate in a high voltage domain and be coupled to a gate of a power switch.

In one or more embodiments the gate driver comprises a package comprising a third die, including third circuitry, in addition to the first die and the second die, wherein the third die is galvanically isolated from the first die and is configured to operate in the high voltage domain and wherein communication between the first circuitry and the third circuitry is provided via the second circuitry and the communication channel.

According to a second aspect of the present disclosure there is provided a system comprising at least two gate drivers according to the first aspect, a first power switch and a second power switch, and an electric motor wherein the electric motor is powered at least in part by the first power switch controlled by the first gate driver and the second power switch controlled by the second gate driver.

According to a third aspect of the present disclosure there is provided an electric vehicle comprising the system the second aspect wherein the electric motor provides motive power for the electric vehicle.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

### Brief Description of the Drawings

One or more embodiments will now be described by way of example only with reference to the accompanying drawings in which:
Figure 1 shows a top view of an example embodiment of a gate driver comprising a package containing a plurality of dies for controlling the gate of a power switch;
Figure 2 shows a side view of the example embodiment of the package of figure 1 showing a stacked arrangement of the dies and a galvanically isolating layer therebetween;
Figure 3 shows example waveforms of received signals and illustrates a the received signal amplitude;
Figure 4 shows example waveforms of received signals and illustrates the received signal frequency;
Figure 5 shows an example system comprising a first gate driver and a second gate driver respectively coupled to first and second power switches which may control the operation of an electric motor; and
Figure 6 shows an example of a vehicle including the system of figure 5.

### Detailed Description

Control of high voltage traction inverters such as for operating a traction motor or other electrical devices is difficult due to the need to operate in a high voltage domain. Control is usually accomplished by relaying signals into a low voltage domain and then communicating by a pulsed width modulation (PWM) communication scheme to a microcontroller (MCU) in the low voltage domain.

In general terms, we present a gate driver that utilizes a galvanic isolation layer and an inductively or capacitively coupled communication channel for connecting different gate drivers and allowing communication between different gate drivers in the high voltage (HV) domain. Overtime, this galvanic isolation layer can age and its isolation properties can degrade. This can lead to faults such as a voltage breakdown across the galvanic isolation layer leading to undesired performance, error prone communication and fault conditions.

It may be possible for the isolation provided by the galvanic isolation layer to be tested using high voltage discharge measurement and examining leakage current. This is typically done using very high voltages and is typically performed as an initial test during manufacture of the gate driver and products containing such gate drivers. However, such testing cannot be performed during use of the gate driver. Typically, the degradation or failure of the galvanic isolation layer is only realized upon the detection of a fault condition. This can lead to unsafe conditions and/or catastrophic failures.

It is therefore desirable to know the state of the galvanic isolation layer and to monitor changes in the isolation provided by the galvanic isolation layer as the barrier degrades prior to any fault conditions being initiated. This can allow the gate drivers to operate effectively and can ensure that any feedback received through the galvanic isolation layer that is used to compensate the operation of the different gate drivers is reliable.

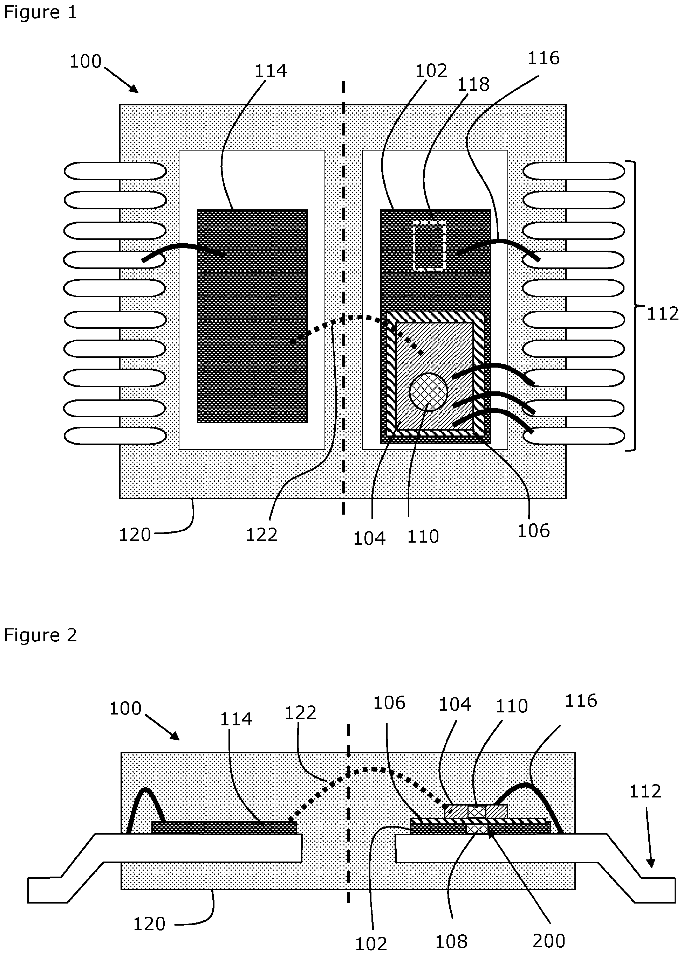

Example figures 1 and 2 together show a gate driver 100 which comprises a first die 102 including first circuitry configured to operate in a first voltage domain. The first circuitry may be embodied by one or more electronic components provided on the first die 102. A second die 104 is stacked with the first die 102 and is galvanically isolated therefrom by a galvanic isolation layer 106. The galvanic isolation layer may be placed between the first die 102 and the second die 104 to provide an electrically isolating barrier therebetween. The galvanic isolation layer 106 allows for the first die 102 and the second die 104 to operate in different voltage domains whilst remaining in close proximity. In the present example, the second die 104 is stacked on the first die 102, although an alternative stacking is possible.

It will be appreciated that the galvanic isolation layer 106 may be formed of a capacitive oxide layer, such as for example capacitive-SiO₂ or may be formed of a different capacitive isolator material. In some examples the galvanic isolation layer 106 may be formed of the die-attach film used to attach the first die 102 to the second die 104. Other insulating materials may be used. Deterioration of the die-attach film can develop over time due to various aging effects such as the corona charge effect in which rapidly changing voltages cause charging and discharging of the distributed parasitic capacitances between two stacked die. In one or more examples, we monitor the galvanic isolation layer 106 to ensure adequate voltage holdoff can be maintained during use of the gate driver 100.

The galvanic isolation layer 106 needs to be suitable for insulating against the voltage difference between the voltage domain of the first die 102 and the voltage domain of the second die 104 that is stacked with the first die 102. The galvanic isolation layer prevents undesired current flows between the two dies. The galvanic isolation layer 106 used therefore needs to be able to insulate against a larger voltage difference when the first die 102 and the second die 104 operate in different voltage domains (i.e. High Voltage (HV) and Low Voltage (LV)) and the galvanic isolation layer can be less resilient to an applied voltage difference when the first die 102 and the second die 104 operate in voltage domains at the same or similar high or low voltage levels wherein this leads to a smaller voltage difference across the galvanic isolation layer 106.

The second die 104 comprises second circuity (not shown). The second circuitry may be embodied by one or more electronic components provided on the second die 102. The second circuitry may be configured to operate in a second voltage domain that is different to the first voltage domain. In some examples the second voltage domain may be the high voltage (HV) domain and the second die 104 may operate in the high voltage (HV) domain. In some other examples the second voltage domain may be the low voltage (LV) domain and the second die 104 may operate in the low voltage (LV) domain.

In the present examples, the first circuitry of the first die 102 includes a first coil 108 and the second circuitry of the second die 104 includes a second coil 110. The first and second coils 108, 110 are configured to provide for an inductively coupled communication channel 200 through the galvanic isolation layer 106 between the first circuitry and the second circuitry. In other examples, the first circuitry of the first die 102 includes a first plate and the second circuitry of the second die 104 includes a second plate and the communication channel comprises a capacitive communication channel.

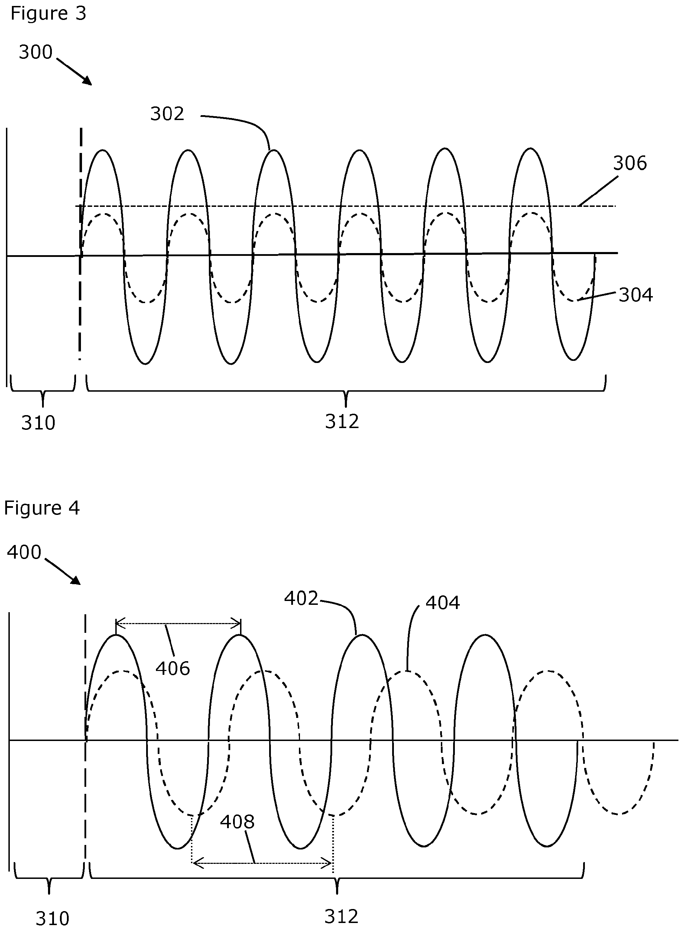

The gate driver 100 also comprises monitoring circuitry 118 (shown schematically as part of the first circuity). The monitoring circuitry is configured to receive signalling from the inductive communication channel 200. It has been found that properties of the received signalling may be used to evaluate the state of the galvanic isolation layer 106. The monitoring circuitry 118 is configured to determine deterioration of the galvanic isolation layer 106 based on one or more of an amplitude, a power, a received signal strength indicator (RSSI) value and a frequency of the received signalling relative to a respective threshold (this will be discussed in relation to figures 3 and 4 later in the description).

Thus, to summarise, the gate driver 100 may comprise a first die in a first voltage domain (LV) and the second die 104 may be in a second different voltage domain (HV) with a galvanic isolation layer 106 therebetween. In general, the galvanic isolation layer 106 may degrade over time and the inductive communication channel 200 can be used to determine the state of the galvanic isolation layer 106 by monitoring the signals received via the galvanic isolation layer 106. In particular, the amplitude and/or the frequency of the received signalling can be monitored to determine changes to the galvanic isolation layer 106.

Figure 1 also shows that the gate driver 100 comprises a plurality of terminals 112. One or more of the terminals 112 may couple the first circuitry of the first die 102 to a supply voltage and a reference voltage. One or more of the terminals 112 may provide for connection of the first circuitry to the gate of the power switch it is configured to control. One or more of the terminals 112 may provide signalling of a fault to the first circuitry of the first die 102. One or more bondwires 116 may couple the respective dies 102, 104 or circuitry thereon to terminals 112. One or more of the terminals 112 may couple the second circuitry of the second die 104 to a different supply voltage and/or a different reference voltage.

In some examples the monitoring circuitry 118 may be part of the second circuitry on the second die 104. In other examples, as shown in figure 1, the monitoring circuitry 118 may be part of the first circuitry on the first die 102. In some examples both of the first die 102 and the second die 104 may have respective monitoring circuitry thereon. This can allow for additional measurements to be taken to confirm the state of the galvanic isolation layer 106. In some examples, measurements of the properties of the received signalling are made by a first part of the monitoring circuitry on one die and that information is communicated to the other die comprising a second part of the monitoring circuitry is located for comparison to the threshold.

The respective threshold which is used to determine deterioration of the galvanic isolation layer 106 can be set during the manufacture of the gate driver 100 or may be determined during installation of the gate driver 100 in a particular apparatus. In such examples the respective threshold is a predetermined absolute threshold. This threshold may be set once and does not change. In other examples, the respective threshold(s) may be dynamic. In the present example, the first circuitry on the first die 102 is configured to operate in a low voltage domain and is configured to be coupled to a microcontroller (not shown) via the one or more of the terminals 112. The microcontroller also operates in the same voltage domain as the first circuitry, i.e. in the low voltage domain. In the example of figure 1, the second circuitry on the second die 104 is configured to operate in a high voltage (HV) domain and may be coupled to a gate of a power switch.

Figure 1 further shows an example in which the gate driver 100 comprises a package 120 comprising a third die 114. The third die 114 comprises third circuitry (not shown) in addition to the circuitry on the first die 102 and the second die 104. The third die 114 is galvanically isolated from the first die 102 and is configured to operate in the high voltage (HV) domain. Communication between the first circuitry on the first die 102 and the third circuitry on the third die 114 is provided via the second circuitry on the second die 104 and the inductive communication channel 200 therebetween. In some examples the second die 104 and the third die 114 are coupled by way of bondwires 122. This is possible because in the example of figure 1 both the second die 104 and the third die 114 are in the same voltage domain and do not require additional isolation.

Figures 3 and 4 each show representative wave forms 300, 400 indicating received signals 302, 304, 402, 404. Figure 3 further shows an example of a respective threshold 306 for use in assessing the amplitude of the received signalling 302, 304.. It will be appreciated that the respective threshold 306 is used as a criteria by the monitoring circuitry 118 to determine the state of the galvanic isolation layer 106.

Figure 3 may be considered to show an example in which the amplitude of the signalling received from the inductive communication channel 200 is used as an indication of the state of the galvanic isolation layer 106. Trace 302 shows an example of the amplitude of the received signalling when the galvanic isolation layer 106 is healthy. In some examples the amplitude of the received signalling 302 need only be above the respective threshold 306 to indicate that the galvanic isolation layer 106 is healthy. Line 306 shows the level of the respective threshold as an amplitude threshold used by the monitoring circuitry 118 to determine if the galvanic isolation layer 106 has degraded below an acceptable level. Trace 304 shows an example of the received signalling having an amplitude less than the amplitude threshold 306. Thus, upon receipt of the signalling 304, the monitoring circuitry 118 may determine that the galvanic isolation layer 106 has degraded and may be deemed unhealthy.

In the present example, the amplitude threshold 306 may be defined as an absolute value. In other examples, the threshold may be set as a ratio of the transmitted signalling to the received signalling 302, 304.

Figure 3 is equally illustrative of a power of the received signalling and a power-based threshold or a received signal strength indicator (RSSI) value and a RSSI based threshold.

Figure 3 further shows a first period of time 310 during which, the gate driver 100 operates in a first mode of operation, such as a calibration mode, and a second period of time 312 during which, the gate driver 100 operates in a second, e.g. operating, mode of operation 312.

In some examples, use of a threshold 306 that is predetermined may not be suitable, such as in cases where some change to the galvanic isolation layer 106 is to be expected during use. In such cases the gate driver 100 may initially operate in a calibration mode whereby the respective threshold 306 is set during the calibration mode by monitoring the received signalling during this period and determining a suitable threshold. The calibration mode may be executed each time the gate driver 100 is activated or when first activated after manufacture. In such examples the respective threshold may be a value determined from one or more of an average amplitude, an average power, an average received signal strength indicator (RSSI) value and an average frequency signal obtained over the first time period 310.

In other examples the calibration mode 310 may only be initiated periodically at predetermined times which can be programmed into the gate driver or which can be initiated by the microcontroller. In other examples the calibration mode may only be initiated after determining that a certain period of time after the last calibration has lapsed or after a certain period of time of using the gate driver 100.

In other examples, the setting of the threshold may benefit from knowledge of the amplitude, power, or frequency of the transmitted signalling, so that the effect of the isolation layer 106 it can be appreciated more accurately and/or account for variation of the transmitted amplitude/power/frequency. Thus, in some examples, the monitoring circuitry 118 may receive information indicative of the transmitted signal amplitude (or other signal property) encoded in the received signalling. The monitoring circuitry 118 may then set the threshold based on the transmitted signal amplitude (or other signal property). In further examples, the respective threshold 306 itself may be transmitted to the monitoring circuitry 118 from one of the first circuitry or the second circuitry. In such examples the respective threshold 306 may be based on one or more of a corresponding amplitude, a corresponding power, a corresponding transmitted signal strength indicator value and a corresponding frequency of signalling that is transmitted via the inductive communication channel 200.

Alternatively or in addition to monitoring the amplitude 300 of the received signal, other parameters can also be monitored so as to allow the state of the galvanic isolation layer 106 to be determined. One such example can include monitoring the frequency of the received signalling 404. In a particular example of the gate driver 100, the monitoring circuitry 118 may be configured to determine deterioration of the galvanic isolation layer 106 based on the frequency of the received signalling 404 relative to the corresponding respective threshold.

Figure 4 illustrates an examples in which the monitoring circuitry 118 may monitor the frequency of the received signalling 404 and compare this to an absolute threshold value or to the frequency of the transmitted signalling (which may be communicated to the monitoring circuitry). In some examples the monitoring circuitry may be configured to determine the period 406, 408 of the received signalling 404 and compare this to the period of the transmitted signalling. The frequency can be determined from the period. The predetermined threshold may be defined as an allowable change in frequency between the transmitted signalling and the received signalling 404. In other examples, the phase of the received signalling 404 may be compared to the phase of the transmitted signalling and a phase shift determined. The phase shift may be compared to a corresponding threshold to provide an indication of the deterioration of the isolation layer.

In some examples the monitoring circuitry may monitor both the amplitude and the frequency of the received signalling 302, 304, 402, 404 to determine the state of the galvanic isolation layer 106.

In some examples the monitoring circuitry 118, upon determination of the deterioration of the galvanic isolation layer 106, may output a warning signal. The warning signal can subsequently allow for the gate driver 100 to be repaired or replaced prior to any voltage breakdown events between the first die 102 and the second die 104.

This approach can also allow for the gate driver 100 to be monitored and to be replaced only when the performance of the galvanic isolation layer falls below a predetermined level. This can mitigate the reliance on a purely time based maintenance schedule for the gate drivers which can allow for more effective use of equipment by avoiding replacement of components that are still performing within the operating parameters. It will be appreciated that the warning signal may be directly output by the monitoring circuitry. In other examples the monitoring circuitry may be configured to output a flag or other signal that can be used to generate a warning signal. This warning signal can be used to cease operations of the gate driver or may inform potential users that a fault is likely and can also be used to schedule maintenance tasks as needed.

It will also be appreciated that in order to conserve power, the monitoring circuitry 118 may not be activated throughout the operation of the gate driver 100. In some examples the monitoring circuitry may be active for only certain periods of time during operation of the gate driver 100. For example the monitoring circuitry may only be activated during start-up of the gate driver 100. In other examples the monitoring circuit may be in a dormant state and may be woken up periodically to monitor the state of the galvanic isolation layer.

In the above examples, the monitoring circuitry 118 may be configured to periodically awake from a low power state or dormant state. It will be appreciated that the low power or dormant state will consume less power than when the monitoring circuit is in its normal state. The monitoring circuitry 118 may also be configured to make said determination of the deterioration of the galvanic isolation layer 106 and subsequently return to the low power state once the determination has been made. This reduces power consumption and also avoids unnecessary monitoring of the gate driver and saves on processing time and other resources.

In other embodiments, the concept of detecting a failing galvanic isolation layer could be applicable to a much wider space than gate drivers. For example, in medical, automotive, and consumer products there may be stacked dies where the monitoring circuitry may be useful for detecting failing isolation. We therefore disclose an apparatus comprising: a first die including a first circuitry configured to operate in a first voltage domain; a second die stacked with the first die and galvanically isolated therefrom by a galvanic isolation layer therebetween, the second die comprising second circuity; wherein the first circuitry of the first die and the second circuitry of the second die provide an inductive or capacitive communication channel through the galvanic isolation layer between the first circuitry and the second circuitry; and monitoring circuitry configured to receive signalling from the inductive communication channel, the monitoring circuitry configured to determine deterioration of the galvanic isolation layer based on one or more of an amplitude, a power, a received signal strength indicator value, a phase shift and a frequency of the received signalling relative to a respective threshold.

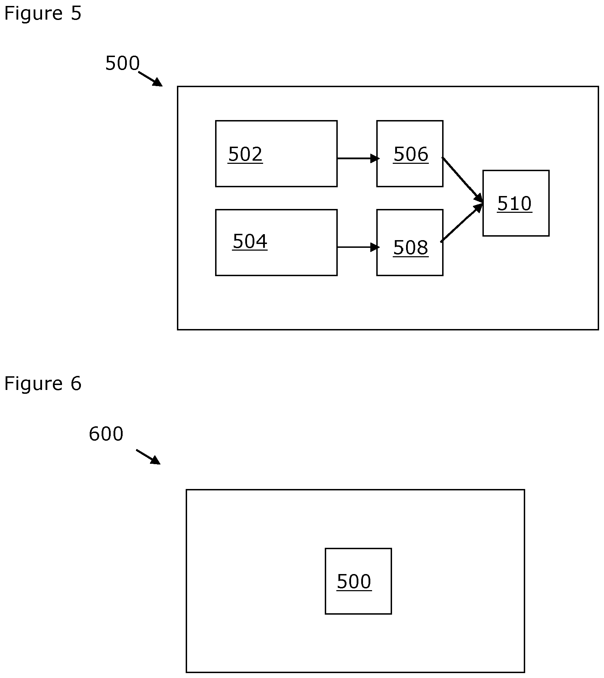

Figure 5 shows a system 500 comprising at least two gate drivers 502, 504, these gate drivers are equivalent to the gate driver 100. Each of the at least two gate drivers 502, 504 is coupled to a gate (not shown) of a first power switch 506 and a second power switch 508 respectively. Each of the first and second power switches 506, 508 are also coupled to an electric motor 510 wherein the electric motor 510is powered at least in part by the first power switch 502 controlled by the first gate driver 502 and the second power switch 508 controlled by the second gate driver 504.

In general the second gate driver is substantially similar in structure to the first gate driver 100.

Figure 6 shows an example embodiment including an electric vehicle 600 comprising the system 500 and wherein the electric motor 510 provides motive power for the electric vehicle 600.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. A gate driver comprising:
a first die including a first circuitry configured to operate in a first voltage domain;
a second die stacked with the first die and galvanically isolated therefrom by a galvanic isolation layer therebetween, the second die comprising second circuity;
wherein the first circuitry of the first die and the second circuitry of the second die are configured to provide one of an inductive and capacitive communication channel through the galvanic isolation layer between the first circuitry and the second circuitry; and
monitoring circuitry configured to receive signalling from the communication channel, the monitoring circuitry configured to determine deterioration of the galvanic isolation layer based on one or more of an amplitude, a power, a received signal strength indicator value, a phase shift and a frequency of the received signalling relative to a respective threshold.

2. The gate driver of claim 1, wherein the respective threshold is a predetermined absolute threshold.

3. The gate driver of claim 1, wherein the respective threshold is a value determined from one or more of an average amplitude, an average power, an average received signal strength indicator value, an average phase shift and an average frequency signal obtained over a calibration time period.

4. The gate driver of claim 1, wherein the respective threshold is based on one or more of a corresponding amplitude, a corresponding power, a corresponding transmitted signal strength indicator value, a corresponding phase and a corresponding frequency of signalling that is transmitted via the communication channel.

5. The gate driver of claim 4, wherein information indicative of said one or more of the corresponding amplitude, power, transmitted signal strength indicator value, phase and frequency of signalling that is transmitted via the inductive communication channel is communicated via the communication channel for determination of the respective threshold.

6. The gate driver of any preceding claim, wherein the monitoring circuitry is configured to determine deterioration of the galvanic isolation layer based on the frequency of the received signalling relative to the respective threshold, wherein the monitoring circuitry is configured to determine changes in the period of the received signalling and the respective threshold is indicative of a threshold level of changes in the period.

7. The gate driver of any preceding claim, wherein the monitoring circuitry is part of the second circuitry.

8. The gate driver of any preceding claim, wherein the monitoring circuitry is part of the first circuitry.

9. The gate driver of any preceding claim, wherein the galvanic isolation layer comprises one of Silicon Oxide and die attach film.

10. The gate driver of any preceding claim, wherein based on determination of the deterioration of the galvanic isolation layer, the monitoring circuitry is configured to output a warning signal.

11. The gate driver of any preceding claim, wherein the monitoring circuitry is configured to periodically awake from a low power state, make said determination of the deterioration of the galvanic isolation layer and return to the low power state.

12. The gate driver of any preceding claim, wherein the first circuitry is configured to operate in a low voltage domain and be coupled to a microcontroller and the second circuitry is configured to operate in a high voltage domain and be coupled to a gate of a power switch.

13. The gate driver of claim 12, wherein the gate driver comprises a package comprising a third die, including third circuitry, in addition to the first die and the second die, wherein the third die is galvanically isolated from the first die and is configured to operate in the high voltage domain and wherein communication between the first circuitry and the third circuitry is provided via the second circuitry and the communication channel.

14. A system comprising at least two gate drivers according to any preceding claims, a first power switch and a second power switch, and an electric motor wherein the electric motor is powered at least in part by the first power switch controlled by the first gate driver and the second power switch controlled by the second gate driver.

15. An electric vehicle comprising the system of claim 14 wherein the electric motor provides motive power for the electric vehicle.
